# EUROPÄISCHE PATENTANMELDUNG

(11) **EP 2 276 081 A2**
(43) Veröffentlichungstag der Anmeldung: **19.01.2011**
(21) Anmeldenummer: 10182075.1
(22) Anmeldetag: 13.11.2000
(51) Int. Cl.: H01L 35/16, H01L 35/22, C01G 43/00, C01G 29/00, C01B 19/00, C01F 11/00, C01G 45/00, C01G 49/00, C01G 51/00, C01G 17/00, C01G 21/00, C01G 23/00, C01G 25/00, C01G 37/00, C01G 39/00, C01G 41/00, C22C 32/00, H01L 35/18

(54) **Thermoelektrisch aktive Materialien und diese enthaltende Generatoren**

(30) Priorität: 19.11.1999 DE 19955788
(62) Teilanmeldung aus: 00124259.3
(71) Anmelder: BASF SE, 67056 Ludwigshafen (DE)
(72) Erfinder: Sterzel, Hans-Josef, 67125, Dannstadt-Schauernheim (DE)
(74) Vertreter: Féaux de Lacroix, Stefan

(57) **Zusammenfassung**

Zu einem Generator mit einem p- oder n-dotierten Halbleitermaterial ist das Halbleitermaterial ein mindestens ternäres Material aus der nachfolgenden Stoffklasse, das sich durch Kombination von mindestens 2 Verbindungen der Stoffklasse ergibt: Antimonide.

## Beschreibung

Die Erfindung betrifft thermoelektrisch aktive Materialien und diese enthaltende Generatoren sowie Verfahren zur Herstellung und Testung der thermoelektrisch aktiven Materialien und hierbei erhaltene Arrays.

Thermoelektrische Generatoren als solche sind seit langem bekannt. p- und n- dotierte Halbleiter, die auf einer Seite erhitzt und auf der anderen Seite gekühlt werden, transportieren elektrische Ladungen durch einen äußeren Stromkreis, an einem Verbraucher im Stromkreis wird dabei elektrische Arbeit verrichtet. Der dabei erzielte Wirkungsgrad der Konversion von Wärme in elektrische Energie wird thermodynamisch durch den Carnot - Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Leider werden bis heute nur Wirkungsgrade bis 10 % erzielt.

Einen guten Überblick über Effekte und Materialien gibt z. B. Cronin B. Vining, ITS Short Course on Thermoelectricity, Nov. 8, 1993 Yokohama, Japan.

Gegenwärtig werden thermoelektrische Generatoren in Raumsonden zur Erzeugung von Gleichströmen, für den kathodischen Korrosionsschutz von Pipelines, zur Ernergieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit, sie arbeiten unabhängig von atmosphärischen Bedingungen wie Luftfeuchte, es erfolgt kein störungsanfälliger Stofftransport, sondern nur ein Ladungstransport; der Betriebsstoff wird kontinuierlich - auch katalytisch ohne freie Flamme- verbrannt, wodurch nur geringe Mengen an CO, NOₓ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit paßt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Es brauchte keine Änderung am vorhandenen Tankstellennetz vorgenommen zu werden. Für eine derartige Anwendung wären jedoch Wirkungsgrade größer als 30 % notwendig.

Die Aufgabe der Erfindung besteht deshalb darin, neue, thermoelektrisch aktive Materialien zur Verfügung zu stellen, die höhere Wirkungsgrade als bisher ermöglichen. Kennzeichnend für thermoelektrische Materialien ist der sogenannte Z-Faktor (figure of merit) $Z = \frac{α ⁢ 2 * σ}{K}$
mit dem Seebeck - Koeffizienten α, der elektrischen Leitfähigkeit σ und der Wärmeleitfähigkeit K.

Eine genauere Analyse ergibt, daß der Wirkungsgrad η sich ergibt aus $η = \frac{{T}_{hoch} - {T}_{niedrieg}}{{T}_{hoch}} * \frac{M - 1}{M + \frac{{T}_{hoch}}{{T}_{niedrieg}}}$
mit ${M = \left[1+\frac{Z}{2}⁢\left({T}_{hoch}-{T}_{niedig}\right)\right]}^{½}$ (siehe auch Mat. Sci. and Eng. B29 (1995) 228).

Das Ziel ist damit, ein Material mit einem möglichst hohen Wert für Z und hoher realisierbarer Temperaturdifferenz bereitzustellen. Aus der Sicht der Festkörperphysik sind hierbei viele Probleme zu bewältigen:

Ein hohes α bedingt eine hohe Elektronenbeweglichkeit im Material; d.h. Elektronen (oder Löcher bei p-leitenden Materialien) dürfen nicht stark an die Atomrümpfe gebunden sein. Materialien mit hoher elektrischer Leitfähigkeit weisen meist gleichzeitig eine hohe Wärmeleitfähigkeit auf (Wiedemann - Franzsches Gesetz), wodurch Z nicht günstig beeinflußt werden kann. Gegenwärtig eingesetzte Materialien wie Bi₂Te₃, PbTe oder SiGe stellen schon Kompromisse dar. So wird die elektrische Leitfähigkeit durch Legieren weniger herabgesetzt als die Wärmeleitfähigkeit. Deshalb setzt man vorzugsweise Legierungen ein wie z. B. (Bi₂T₃)₉₀ (Sb₂T₃)₅ (Sb₂Se₃)₅oder Bi₁₂ Sb₂₃ Te₆₅, wie sie in der US 5, 448, 109 beschrieben sind.

Für thermoelektrische Materialien mit hohem Wirkungsgrad sind vorzugsweise noch weitere Randbedingungen zu erfüllen. Vor allem müssen sie temperaturstabil sein, um bei Arbeitstemperaturen von 1000 bis 1500 K über Jahre ohne wesentlichen Wirkungsgradverlust arbeiten zu können. Dies bedingt sowohl hochtemperaturstabile Phasen an sich, eine stabile Phasenzusammensetzung, wie auch eine zu vernachlässigende Diffusion von Legierungsbestandteilen in die anliegenden Kontaktmaterialien.

Die Aufgabe wird erfindungsgemäß gelöst durch einen thermoelektrischen Generator mit einem p- oder n- dotierten Halbleitermaterial, wobei das Halbleitermaterial ein mindestens ternäres Material aus einer der nachfolgenden Stoffklassen ist, das sich durch Kombination von mindestens 2 Verbindungen der Stoffklasse ergibt:
(1) Silizide
   U₃Si₅, BaSi₂, CeSi₂, GdSi, NdSi₂, CoSi, CoSi₂, CrSi₂, FeSi, FeSi₂, MnSi, MoSi₂, WSi₂, VSi, TiSi₂, ZrSi₂, VSi₂, NbSi₂, sowie TaSi₂
(2) Boride
   UB₂, UB₄, UB₁₂, CeB₆, AlB₁₂, CoB, CrB₂, CrB₄, FeB, MnB, MnB₂, MnB₁₂, MoB, MoB₄, SiB₄, SiB₆, SiB₁₂, TiB₂, VB₂, YB₄, ZrB₂, CuB₂₄, NiB₁₂, BaB₆, MgB₂, MgB₄ sowie MgB₁₂, wobei die aluminiumhaltigen Boride zusätzlich pro B- Atom ein C- Atom enthalten können,
(3) Germanide
   U₅Ge₃, BaGe, GdGe, Dy₅Ge₃, Fr₅Ge₃ sowie Ce₃Ge₅
(4) Telluride, Sulfide und Selenide
   LaS, NdS, Pr₂S₃, DyS, USe, BaSe, GdSe, LaSe, Nd₃Se₄, Nd₂Se₃, PrSe, FrSe, UTe, GdTe, LaTe, NdTe, PrTe, SmTe, DyTe sowie ErTe
(5) Antimonide
   USb, CeSb, GdSb, LaSb, NdSb, PrSb, DySb, AlSb, CoSb, CrSb, FeSb, Mg₃Sb₂, Ni₅Sb₂ sowie CoSb₃ und NiSb₃
(6) Plumbide
   CePb, Gd₅Pb₃, La₅Pb₃ sowie Dy₅Pb₄ wobei in den Stoffklassen (1) bis (6) bis zu 10 Atom - % der Elemente ersetzt sein können durch Na, K, Rb, Cs, Zn, Cd, Al, Ga, Zr, Mg, S, Cu, Ag, Au, Ti, V, Nb, Ta, Cr, Mo, W, Mn, Re, Fe, Co, Ni, oder Gemischen davon, sofern sie nicht bereits in den Kombinationen vorliegen.
(7) Halbleitenden Oxide
   UO₂, Bi₂O₃, CuO, Cu₂O, SnO, PbO, ZnO, In₂O₃, WO₃, V₂O₅, Sb₂O₃,CoO, NiO, Co₃O₄, FeO, Fe₂O₃, NbO₂, CeO₂ sowie BaO,
   wobei bis zu 10 Mol -% der Oxide ersetzt sein können durch Na₂O, K₂O, CdO, SrO, Al₂O₃, Ga₂O₃, Cr₂O₃, oder Gemische davon. Vorzugsweise ist das Halbleitermaterial eine binäre oder ternäre Legierung aus einer der Stoffklassen (1) bis (6) oder ein binäres Oxid aus der Stoffklasse (7), wobei keine Oxide oder Elemente wie angegeben ersetzt sind. Nach einer weiteren Verfahrensweise ist es möglich, 30 bis 50, vorzugsweise 35 bis 40 Gew.-% eines oder mehrerer der halbleiterbildenden Elemente B, Si, Ge, Sb, Bi, S, Se und Te mit 50 bis 70, vorzugsweise 60 bis 65 Gew.-% eines oder mehrerer der Elemente Mg, Al, Fe, Ni, Co, Zn, Cd, Ti, Zr, Y, Cu, V, Mo, W, Mn, Nb, Ta und U zu kombinieren und umzusetzen, um zu thermoelektrisch aktiven Materialien zu gelangen. Dazu werden diese Materialien wie später beschrieben in geeigneter kombinatorischer Weise miteinander kombiniert und die Elementmischungen bei erhöhten Temperaturen anschließend zu den eigentlichen thermoelektrisch aktiven Materialien durch Festkörperreaktion umgesetzt.

Der Anteil an Dotierungselementen beträgt bis zu 0,1 Atom-% in der Legierung oder 10¹⁸ bis 10²⁰ Ladungsträger pro Kubikzentimeter. Höhere Ladungsträgerkonzentrationen bewirken nachteilige Rekombinationen und damit eine reduzierte Ladungsbeweglichkeit. Dotiert wird mit Elementen, die einen Elektronenüber- oder Unterschuß im Kristallgitter bewirken, z. B. mit Jodid für n-Halbleiter und Erdalkalielementen für p-Halbleiter, sofern ein 3/5- oder 3/6-Halbleiter vorliegt.

Eine weitere Möglichkeit der Dotierung ergibt sich dadurch, daß man gezielt durch unter-oder überstöchiometrische Zusammensetzungen Löcher oder Elektronen in die Materialien einbringt und sich damit einen zusätzlichen Dotierschritt erspart.

Dotierelemente können auch über die wässrigen Lösungen von Metallsalzen eingebracht werden, die anschließend in der Mischung getrocknet werden. Anschließend werden die Metallkationen z.B. durch Wasserstoff bei erhöhten Temperaturen reduziert oder verbleiben ohne Reduktion im Material. Bevorzugt erfolgt die p- oder n- Dotierung durch Wahl der Mengenverhältnisse der Verbindungen oder die p- Dotierung mit Alkalimetallen und die n- Dotierung mit Sb, Bi, Se, Te, Br, oder I (siehe WO 92/13811).

Es ist vorteilhaft, schwere Elemente einzusetzen, von denen bekannt ist, daß ihre thermische Austrittsarbeit niedrig ist. Als solche sind vor allem U, Bi, Se, Te, Ce, Ba bekannt.

Materialien im Sinne der Erfindung ergeben sich aus der Kombination von mindestens zwei Verbindungen aus den vorstehend ausgeführten Stoffklassen. Die binären Stammverbindungen zeichnen sich durch hohe Schmelzpunkte, kongruente Schmelzen und vergleichsweise hohen Seebeck - Koeffizienten aus. Zudem weisen sie alle Halbleitereigenschaften auf wie beispielsweise einen Anstieg der elektrischen Leitfähigkeit bei Temperaturerhöhung.

In der kombinatorischen Synthese und Testung werden diese binären Verbindungen eingesetzt, um aus deren Kombinationen thermoelektrische Materialien mit hohem Z - Wert zu erhalten.

Es wurde nun gefunden, daß vorzugsweise als Grundlage für thermoelektrische Materialien mit hohem Z sowie hoher Arbeitstemperatur die folgenden binären Legierungen attraktiv sind:

| Material | Schmelzpunkt (°C) |
|---|---|
| UB₂ | 2385 |
| UB₄ | 2495 |
| UB₁₂ | 2235 |
| U₅Ge₃ | 1670 |
| USb | 1850 |
| U₃Si₅ | 1770 |
| USe | 1990 |
| UTe | 1740 |
| BaGe | 1145 |
| BaSe | 1780 |
| BaSi₂ | 1180 |

Weitere geeignete binäre Materialien mit hoher Temperaturbeständigkeit - Schmelzpunkte in °C in Klammern - sind die Germanide GdGe (1790), Dy₅Ge₃ (1825), Er₅Ge₃ (1950); die Antimonide GdSb (2130), LaSb (1690), NdSb (2100), PrSb (2170), DySb (2170); die Plumbide CePb (1380), Gd₅Pb₃ (1670), La₅Pb₃ (1450), Dy,₅Pb₄ (1695); die Silizide GdSi (2100), NdSi₂ (1757), die Selenide GdSe (2170), LaSe (1950), Nd₃Se₄, Nd₂Se₃, PrSe (2100), ErSe (1630); die Telluride GdTe (1825), LaTe, (1720), NaTe (2025), PrTe (1950), SmTe (1910), DyTe (1850), ErTe (1790) sowie die Sulfide LaS (2300), NdS (2200), Pr₂S₃ (1795) und DyS (2370).

| Weiterhin: | |
|---|---|
| CeB₆ | 2550 |
| Ce₃Ge₅ | 1513 |
| CeSb | 1800 |
| CeSi₂ | 1430 |
| CeTe | 1820 |
| Ce₄Bi₃ | 1740 |
| CePb | 1380 |

Aus diesen leiten sich die folgenden bevorzugten ternären Materialien ab, wobei x von 0,01 bis 0,99 vorzugsweise von 0,05 bis 0,95 beträgt:
U₁₊₄ₓB₂₋₂ₓGe₃ₓ
USbₓB₂₋₂ₓ
U₁₊₂ₓ B₂₋₂ₓSi₅₋ₓ
UB₂₋₂ₓSiₓ
UB₂₋₂ₓTeₓ
UₓBa₁₋ₓSe
(UₓBa₁₊ₓ)₅Ge₅₋₂ₓ
(UₓBa₁₋ₓ)₃Si₆₋ₓ
UₓCe₁₋ₓB₆₊₆ₓ
U₅₋₅ₓCe₃ₓGe₃₊₂ₓ
UₓCe₁₋ₓSb
U₃₋₃ₓCeₓSi₅₋₃ₓ
UₓCe₁₋ₓTe
U₃₋₂ₓSi₅₋₅ₓSe_{X}
U₃₋₂ₓSi₅₋₅ₓTeₓ
U₃₋₃ₓBaₓSi₅₋₃ₓ
USbₓTe₁₋ₓ
USbₓSe₁₋ₓ
USeₓTe₁₋ₓ
UₓBa₁₋ₓSe
UₓCe₁₋ₓTe
BaₓCe₃₋₃ₓGe₅₋₄ₓ
BaSeₓSi₂₋₂ₓ
BaCe₁₋ₓSi₂
SeₓGe₁₋ₓBa
SeₓSi₂₋₂ₓBa
(UₓGd₁₊ₓ)₅Ge₅₋₂ₓ
(UₓDy₁₋ₓ)₅Ge₃
(UₓEr₁₋ₓ)₅Ge₃
UₓGd₁₋ₓSb
UₓLa₁₋ₓSb
UₓNd₁₋ₓSb
UₓPr₁₋ₓSb
UₓDy₁₋ₓSb
U₃₋₃ₓGdₓSi₅₋₄ₓ
U₃₋₃ₓNdₓSi₅₋₃ₓ
U₃₋₃ₓPrₓSi₅₋₃ₓ
UₓGd₁₋ₓSe
UₓLa₁₋ₓSe
U₃₋₃ₓNd₃ₓSeₓ₊₃
UₓPr₁₋ₓSe
UₓEr₁₋ₓSe
UₓGd₁₋ₓTe
UₓLa₁₋ₓTe
UₓNd₁₋ₓTe
UₓPr₁₋ₓTe
UₓSm₁₋ₓTe
UxDy₁₋ₓTe
UₓDy₁₋ₓTe UₓEr₁₋ₓTe
BaₓGd₁₋ₓGe
Ba₁₋ₓDy₅ₓGe₂ₓ₊₁
Ba₁₋ₓEr₅ₓGe₂ₓ₊₁
BaₓGd₁₋ₓSe
BaₓLa₁₋ₓSe
Ba₁₋ₓNd₃ₓSe₃ₓ₊₁
Ba₁₋ₓNd₂ₓSe₂ₓ₊₁
BaₓPr₁₋ₓSe
BaₓEr₁₋ₓSe
BaₓGd₁₋ₓSiₓ₊₁
BaₓNd₁₋ₓSi₂
BaₓPr₁₋ₓSi₂
Ce₃ₓGd₁₋ₓGe₄ₓ₊₁
Ce₃₋₃ₓDy₅ₓGe₅₋₂ₓ
Ce₃₋₃ₓEr₅ₓGe₅₋₂ₓ
CeₓGd₁₋ₓSb
CeₓLa₁₋ₓSb
CeₓNd₁₋ₓSb
CeₓPr₁₋ₓSb
CeₓDy₁₋ₓSb
CeₓGd₅₋₅ₓPb₃₋₂ₓ
CeₓLa₅₋₅ₓPb₃₋₂ₓ
CeₓDy₅₋₅ₓPb₄₋₃ₓ
CeₓGd₁₋ₓSi₁₊ₓ
CeₓNd₁₋ₓSi₂
CeₓPr₁₋ₓSi₂
GdₓDy₅₋₅ₓGe₃₋₂ₓ
GdₓEr₅₋₅ₓGe₃₋₂ₓ
GdₓLa₁₋ₓSb
GdₓNd₁₋ₓSb
GdₓPr₁₋ₓSb
GdₓDy₁₋ₓSb
GdₓDy₁₋ₓSb
(GdₓLa₁₋ₓ)₅Pb₃
(GdₓDy₁₋ₓ)₅Pb₄₋ₓ
GdₓNd₁₋ₓSi₂₋ₓ
GdₓPr₁₋ₓSi₂₋ₓ
GdₓLa₁₋ₓSe
Gd₁₋ₓNd₃ₓSe₃ₓ₊₁
Gd₁₋ₓNd₂ₓSe₂ₓ₊₁
GdₓPr₁₋ₓSe
GdₓEr₁₋ₓSe
GdₓLa₁₋ₓTe
GdₓNd₁₋ₓTe
GdₓPr₁₋ₓTe
GdₓSm₁₋ₓTe
GdₓDy₁₋ₓTe
GdₓEr₁₋ₓTe
LaₓNd₁₋ₓSb
LaₓPr₁₋ₓSb
LaₓDy₁₋ₓSb
(LaₓDy₁₋ₓ)₅Pb₄₋ₓ
La₁₋ₓNd₃ₓSe₃ₓ₊₁
La₁₋ₓNd₂ₓSe₂ₓ₊₁
LaₓPr₁₋ₓSe
LaₓEr₁₋ₓSe
LaₓNd₁₋ₓTe
LaₓPr₁₋ₓTe
LaₓEr₁₋ₓTe
LaₓDy₁₋ₓTe
LaₓSm₁₋ₓTe
LaₓNd₁₋ₓS
LaₓDy₁₋ₓS
La₁₋ₓPr₂ₓS₂ₓ₊₁
NdₓPr₁₋ₓSb
NdₓDy₁₋ₓSb
NdₓPr₁₋ₓSi₂
Pr₁₋ₓNd₃ₓSe₃ₓ₊₁
Pr₁₋ₓNd₂ₓSe₂ₓ₊₁
Er₁₋ₓNd₃ₓSe₃ₓ₊₁
Er₁₋ₓNd₂ₓSe₂ₓ₊₁
NdₓPr₁₋ₓTe
NdₓSm₁₋ₓTe
NdₓDy₁₋ₓTe
NdₓEr₁₋ₓTe
NdₓDy₁₋ₓS
Nd₁₋ₓPr₂ₓS₂ₓ₊₁
PrₓDy₁₋ₓSb
PrₓEr₁₋ₓSe
PrₓSm₁₋ₓTe
PrₓDy₁₋ₓTe
PrₓEr₁₋ₓTe
Pr₂ₓDy₁₋ₓS₂ₓ₊₁
SmₓDy₁₋ₓTe
SmₓEr₁₋ₓTe
(DyₓEr₁₋ₓ)₅Ge3
DyₓEr₁₋ₓTe

Besonders preiswerte thermoelektrische Materialien sind halbleitende Silizide und Boride mit hohen Si- oder B- Gehalten der Form
Me Siₓ mit x ≥ 1
sowie
Me Bₓ mit x ≥ 1

Diese werden mit Alkalimetallen p- dotiert, mit Sb, Bi, Se, Te, Br oder J n- dotiert.

Bevorzugte binäre Silizide nach der Erfindung sind damit:
Ba Si₂
Co Si
Co Si₂
Cr Si₂
Fe Si
Fe Si₂
Mn Si
Mo Si₂
W Si₂
V Si₂
Fe Si₁₊ₓ x = 0-1
Co Si₁₊ₓ x = 0-1

Bevorzugte binäre Boride nach der Erfindung sind:
Al B₁₂
Co B
Cr B₂ CrB₄
Fe B
Mn B
Mn B₂ Mn B₄ MnB₁₂
Mo B Mo B₄
Si B₆
Si B₄
SiB₁₂
Ti B₂
V B₂
Y B₄
Zr B₂
Cu B₂₄
Ni B₁₂
Ba B₆
Mg B₂
Mg B₄
Mg B₁₂
UB₂
UB₄
UB₁₂

Von den genannten Siliziden und Boriden leiten sich die folgenden bevorzugten ternären Silizide und Boride ab mit x zwischen 0,01 und 0,99:
Ternäre Silizide
Al₃SiB₄₈
Al₄SiC₄
Al₄Si₃C₆
BaₓCo₁₋ₓSi₁₊ₓ
BaₓCo₁₋ₓSi₂
BaₓCr₁₋ₓSi₂
BaₓFe₁₋ₓSi₁₊ₓ
BaₓMn₁₋ₓSi₁₊ₓ
BaₓMo₁₋ₓSi₂
BaₓW₁₋ₓSi₂
Co₁₋ₓCrₓSi₁₊ₓ
CoₓFe₁₋ₓSi
CoₓMn₁₋ₓSi
Co₁₋ₓMoₓSi₁₊ₓ
Co₁₋ₓWₓSi₁₊ₓ
CoₓCr₁₋ₓSi₂
CoₓFe₁₋ₓSi₁₊ₓ
CoₓMn₁₋ₓSi₁₊ₓ
CoₓMo₁₋ₓSi₂
CoₓW₁₋ₓSi₂
CrₓFe₁₋ₓSi₁₊ₓ
CrₓMn₁₋ₓSi₁₊ₓ
CrₓMo₁₋ₓSi₂
CrₓW₁₋ₓSi₂
FeₓMn₁₋ₓSi
Fe₁₋ₓMoₓSi₁₊ₓ
Fe₁₋ₓWₓSi₁₊ₓ
Mn₁₋ₓMoₓSi₁₊ₓ
Mn₁₋ₓWₓSi₁₊ₓ
MoₓW₁₋ₓSi₂
FeₓBa₁₋ₓSi₂
FeₓCo₁₋ₓSi₁₊ₓ
FeₓCo₁₋ₓSi₂
FeₓCr₁₋ₓSi₂
FeₓMn₁₋ₓSi₁₊ₓ
FeₓMo₁₋ₓSi₂
Feₓw₁₋ₓSi₂
FeₓV₁₋ₓSi₂
VxBa₁₋ₓSi₂
VₓCo₁₋ₓSi₁₊ₓ
VₓCo₁₋ₓSi₂
VₓCr₁₋ₓSi₂
VₓFe₁₋ₓSi₁₊ₓ
VₓMn₁₋ₓSi₁₊ₓ
VₓMo₁₋ₓSi₂
VₓW₁₋ₓSi₂
U₃₋₃ₓCoₓSi₅₋₄ₓ
U₃₋₃ₓCOₓSi₅₋₃ₓ
U₃₋₃ₓCrₓSi₅₋₃ₓ
U₃₋₃ₓFeₓSi₅₋₄ₓ
U₃₋₃ₓFeₓSi₅₋₃ₓ
U₃-₃ₓMnₓSi₅₋₄ₓ
U₃₋₃ₓMoₓSi₅₋₃ₓ
U₃₋₃ₓWₓSi₅₋₃ₓ
U₃₋₃ₓVₓSi₅₋₃ₓ

Ternäre Boride
Co_{X}Mn_{1-X}B
Co_{X}Fe_{1-X}B
Fe_{X}Mn_{1-X}B
Co_{X}Cr_{1-X}B₂
Cr_{X}Mn_{1-X}B₂
Co_{X}Mn_{1-X}B₂
Cr_{X}Ti_{1-X}B₂
Cr_{X}Zr_{1-X}B₂
Co_{X}Zr_{1-X}B₂
Mn_{X}Zr_{1-X}B₂
Co_{X}V_{1-X}B₂
Cr_{X}V_{1-X}B₂
Mn_{X}V_{1-X}B₂
Ti_{X}V_{1-X}B₂
Zr_{X}V_{1-X}B₂
Mn_{X}Ti_{1-X}B₂
Cr_{X}Mg_{1-X}B₄
Cr_{X}Mn_{1-X}B₄
Cr_{X}Mo_{1-X}B₄
Cr_{X}Si_{1-X}B₄
Cr_{X}Y_{1-X}B₄
Mg_{X}Mn_{1-X}B₄
Mg_{X}Mo_{1-X}B₄
Mg_{X}Si_{1-X}B₄
Mg_{X}Y_{1-X}B₄
Mn_{X}Mo_{1-X}B₄
Mn_{X}Si_{1-X}B₄
Mn_{X}Y_{1-X}B₄
Mo_{X}Si_{1-X}B₄
Mo_{X}Y_{1-X}B₄
Si_{X}Y_{1-X}B₄
Al₃B₄₄C₂
Al₈B₄C₇
AlB₁₂C₂
Al₄B₄C_{X}
Al₈B₇C₄
Al₃B₄₈C₂ Mg_{0,78}Al_{0,75}B₁₄ MgAlB₁₄ U_{X}Al_{1-X}B_{12-10X} U_{X}Co_{1-X}B_{1+X} U_{X}Cr_{1-X}B₂ U_{X}Fe_{1-X}B_{1+X} U_{X}Mn_{1-X}B_{1+X} U_{X}Mn_{1-X}B₂ U_{X}Mo_{1-X}B_{1+X} U_{X}Si_{1-X}B_{6-4X} U_{X}Si_{1-X}B_{4-2X} U_{X}Si_{1-X}B_{12-10X} U_{X}Ti_{1-X}B₂ U_{X}V_{1-X}B₂ U_{X}Y_{1-X}B_{4-2X} U_{X}Zr_{1-X}B₂ U_{X}Cu_{1-X}B_{24-22X} U_{X}Ni_{1-X}B_{12-10X} U_{X}Ba_{1-X}B_{6-2X} U_{X}Cr_{1-X}B_{4-2X} U_{X}Mg_{1-X}B₂ U_{X}Mg_{1-X}B_{4-2X} U_{X}Mg_{1-X}B_{12-10X} U_{X}Mn_{1-X}B_{4-2X} U_{X}Mo_{1-X}B_{4-2X} U_{X}Mn_{1-X}B_{12-10X} U_{X}Al_{1-X}B_{12-8X} U_{X}Co_{1-X}B_{1+3X} U_{X}Cr_{1-X}B_{2+2X} U_{X}Fe_{1-X}B_{1+3X} U_{X}Mn_{1-X}B_{1+3X} U_{X}Mn_{1-X}B_{2+2X} U_{X}Mo_{1-X}B_{1+3X} U_{X}Si_{1-X}B_{6-2X} U_{X}Si_{1-X}B₄ U_{X}Si_{1-X}B_{12-8X} U_{X}Ti_{1-X}B_{2+2X} U_{X}V_{1-X}B_{2+2X}
U_{X}Y_{1-X}B₄
U_{X}Zr_{1-X}B_{2+2X}
U_{X}Cu_{1-X}B_{24-20X}
U_{X}Ni_{1-X}B₁₂-_{8X}
U_{X}Ba_{1-X}B_{6-2X}
U_{X}Cr_{1-X}B₄
U_{X}Mg_{1-X}B_{2+2X}
U_{X}Mg_{1-X}B₄
U_{X}Mg_{1-X}B_{12-8X}
U_{X}Mn_{1-X}B₄
U_{X}Mo_{1-X}B₄
U_{X}Mn_{1-X}B_{12-8X}
U_{X}Al_{1-X}B₁₂
U_{X}Co_{1-X}B_{11X+1}
U_{X}Cr_{1-X}B_{10X+2}
U_{X}Fe_{1-X}B_{11X+1}
U_{X}Mn_{1-X}B_{11X+1}
U_{X}Mn_{1-X}B_{10X+2}
U_{X}M_{1-X}B_{11X+1}
U_{X}Si_{1-X}B_{6X+6}
U_{X}Si_{1-X}B_{8X+4}
U_{X}Si_{1-X}B₁₂
U_{X}Ti_{1-X}B_{10X+2}
U_{X}V_{1-X}B_{10X+2}
U_{X}Y_{1-X}B_{8X+4}
U_{X}Zr_{1-X}B_{10X+2}
U_{X}Cu_{1-X}B_{24-12X}
U_{X}Ni_{1-X}B₁₂
U_{X}Ba_{1-X}B_{6X+6}
U_{X}Cr_{1-X}B_{8X+4}
U_{X}Mg_{1-X}B_{10X+2}
U_{X}Mg_{1-X}B_{8X+4}
U_{X}Mg_{1-X}B₁₂
U_{X}Mn_{1-X}B_{8X+4}
U_{X}Mo_{1-X}B_{8X+4}
U_{X}Mn_{1-X}B₁₂

Die Silizide und Boride im Sinne der Erfindung können zusätzlich noch bis zu 20 Atom -% der Elemente Fe, Co, Ni, Mn, Mo und Al in Kombination mit den bereits aufgeführten jeweils anderen Elementen enthalten.

Die binären und ternären Legierungen können noch mit bis zu 10 Atom % anderer Elemente, nämlich Na, K, Rb, Cs, Zn, Cd, Al, Ga, In, Sn, Zr, Hf, S, Cu, Ag, Au, Ti, V, Nb, Ta, Cr, Mo, W, Mn, Re, Fe, Co oder Ni legiert werden.

Auch bevorzugte binäre Oxide (7), die sich im wesentlichen von den bekannten halbleitenden Oxiden UO₂, Bi₂O₃, CuO, Cu₂O, SnO, PbO, ZnO, In₂O₃ ableiten, erfüllen die Bedingungen für thermoelektrische Materialien mit hohem Wirkungsgrad. Diese sind, mit x von 0,01 bis 0,99, vorzugsweise 0,05 bis 0,95,
(InₓBi₁₋ₓ)₂O₃
BaₓSn₁₋ₓO
UₓCe₁ₓO₂
BaₓU₁₋ₓO₂₋ₓ
SnₓU₁₋ₓO₂₋ₓ
PbₓU₁₋ₓO₂₋ₓ
CuₓU₁₋ₓO₂₋ₓ
ZnₓU₁₋ₓO₂₋ₓ
(InₓSb₁₋ₓ)₂O₃
CuₓPb₁₋ₓO
(BiₓSb₁₋ₓ)₂O₃
In₂ₓU₁₋ₓO₂₊ₓ
In₂ₓCe₁₋ₓO₂₊ₓ
In₂ₓBa₁₋ₓO₁₊₂ₓ
In₂ₓSn₁₋ₓO₁₊₂ₓ
In₂ₓPb₁₋ₓO₁₊₂ₓ
In₂ₓCu₁₋ₓO₁₊₂ₓ
In₂ₓZn₁₋ₓO₁₊₂ₓ
Sb₂ₓSn₁₋ₓO₁₊₂ₓ
Bi₂ₓSn₁₋ₓO₁₊₂ₓ
Bi₂ₓPb₁₋ₓO₁₊₂ₓ
Bi₂ₓCU₁₋ₓO₁₊₂ₓ
Bi₂ₓZn₁₋ₓO₁₊₂ₓ
Sb₂ₓBa₁₋ₓO₁₊₂ₓ
Bi₂ₓBa₁₋ₓO₁₊₂ₓ
Bi₂ₓU₁₋ₓO₂₊ₓ
Sb₂ₓU₁₋ₓO₂₊ₓ
Bi₂ₓCe₁₋ₓO₂₊ₓ
Sb₂ₓCe₁₋ₓO₂₊ₓ
CuₓZn₁₋ₓO
Sb₂ₓZn₁₋ₓO₁₊₂ₓ
Sb₂ₓCU₁₋ₓO₁₊₂ₓ
Sb₂ₓPb₁₋ₓO₁₊₂ₓ
PbₓZn₁₋ₓO
PbₓCe₁₋ₓO₂₋ₓ
CuₓCe₁₋ₓO₂₋ₓ
ZnₓCe₁₋ₓO₂₋ₓ
SnₓCe₁₋ₓO₂₋ₓ
BaₓCe₁₋ₓO₂₋ₓ
SnₓZn₁₋ₓO
SnₓCu₁₋ₓO
BaₓZn₁₋ₓO
BaₓCu₁₋ₓO
BaₓPb₁₋ₓO
SnₓPb₁₋ₓO
V₂ₓCu₂₋₂ₓO₁₊₄ₓ
V₂ₓW₁₋ₓO₃₊₂ₓ
V₂ₓCU₁₋ₓO₁₊₄ₓ
V₂ₓPb₁₋ₓO₁₊₄ₓ
V₂ₓZn₁₋ₓO₁₊₄ₓ
V₂ₓCe₁₋ₓO₂₊₃ₓ
V₂ₓSn₁₋ₓO₂₊₃ₓ
V₂ₓBa₁₋ₓO₁₊₄ₓ
(VₓSb₁₋ₓ)₂O₃₊₂ₓ
(VₓBi₁₋ₓ)₂O₃₊₂ₓ
(VₓIn₁₋ₓ)₂O₃₊₂ₓ
V₂ₓU₁₋ₓ0₂₊₃ₓ
V₂ₓCo₁₋ₓO₁₊₄ₓ
V₂ₓNi₁₋ₓO₁₊₄ₓ
WₓCu₂₋₂ₓO₁₊₂ₓ
WₓCu₁₋ₓO₁₊₂ₓ
WₓPb₁₋ₓO₁₊₂ₓ
WₓZn₁₋ₓO₁₊₂ₓ
WₓCe₁₋ₓO₂₊ₓ
WₓSn₁₋ₓO₂₊ₓ
WₓBa₁₋ₓO₁₊₂ₓ
WₓBi₂₋₂ₓO₃
WₓSb₂₋₂ₓO₃
WₓU₁₋ₓO₂₊ₓ
WₓIn₂₋₂ₓO₃
WₓCO₁₋ₓO₁₊₂ₓ
WₓNi₁₋ₓO₁₊₂ₓ
CoₓNi₁₋ₓO
CoₓCu₂₋₂ₓO
CoₓCu₁₋ₓO
CoₓPb₁₋ₓO
CoₓZn₁₋ₓO
CoₓCe₁₋ₓO₂₋ₓ
CoₓSn₁₋ₓO₂₋ₓ
CoₓBa₁₋ₓO
COₓSb₂₋₂ₓO₃₋₂ₓ
CoₓBi₂₋₂ₓO₃₋₂ₓ
CoₓU₁₋ₓO₂₋ₓ
NiₓCu₂₋₂O
NiₓCu₁₋ₓO
NiₓPb₁₋ₓO
NiₓZn₁₋ₓO
NiₓCe₁₋ₓO₂₋ₓ
NiₓSn₁₋ₓO₂₋ₓ
NiₓBa₁₋ₓO
NiₓSb₂₋₂ₓO₃₋₂ₓ
NiₓBi₂₋₂ₓO₃₋₂ₓ
NiₓIn₂₋₂ₓO₃₋₂ₓ
NiₓU₁₋ₓO₂₋ₓ

In diesen Materialien kann Ce ganz oder teilweise durch die Lanthaniden Gd, La, Nd, Pr, Sm, Dy oder Er oder Mischungen davon ersetzt werden.

Die binären Oxide können bis zu 10 Mol-% weitere Oxide enthalten. Derartige Oxide sind Na₂O, K₂O, CdO, SrO, Al₂O₃, Ga₂O₃, Cr₂O₃, WO₃, FeO, Fe₂O₃,CoO sowie NiO. Vorzugsweise ist das Halbleitermaterial ausgewählt aus Siliziden (1) und Boriden (2) wobei der Si- Anteil bzw. B- Anteil mindestens 50 Atom -% beträgt. Die Erfindung betrifft auch die vorstehend beschriebenen Halbleitermaterialien. Die Erfindung betrifft auch ein Verfahren zur Herstellung dieser Halbleitermaterialien durch Sintern oder Zusammenschmelzen und nachfolgend Sintern von Mischungen der Elementpulver oder Sintern von Mischungen der Oxidpulver.

Die erfindungsgemäßen Materialien werden somit nach bekannten Verfahren hergestellt, die Elementverbindungen z.B. durch Sintern der Elementpulver bei hohen Temperaturen, jedoch unterhalb des Schmelzpunkts oder durch Lichtbogenschnielzen im Hochvakuum sowie anschließendes Pulverisieren und Sintern. Die Oxide werden z.B. durch Sintern der Pulvermischungen der Einzeloxide synthetisiert. Der Ausdruck "Kombination", wie er vorstehend benutzt wurde, bezieht sich gerade auf diese Herstellung, insbesondere das Sintern.

Die thermoelektrisch aktiven Mischoxide lassen sich auch durch Reaktivsintern der entsprechenden Metallmischungen in Luft bei erhöhten Temperaturen herstellen. Aus wirtschaftlichen Gründen ist es auch sinnvoll, Mischungen von Oxiden und Metallen einzusetzen. Sehr unedle und deshalb teure und schwer zu handhabenden Metalle wie U, Ba oder Ce wird man als UO₂, BaO oder CeO₂ einsetzen, desgleichen Na als Na₂O, Na₂CO₃ oder NaOH, K als K₂O oder KOH oder K₂CO₃, Sr als SrO oder SrCO₃, Ga als Ga₂O₃.

Ein weiterer Gegenstand der Erfindung ist die Optimierung der Materialien hinsichtlich des Wirkungsgrads. Es liegt auf der Hand, daß bei Variation der Komponenten um beispielsweise 5 Atom- % sehr viele Materialien synthetisiert und geprüft werden müssen. Diese Aufgabe kann mit kombinatorischen Methoden gelöst werden. Dazu können Elementlegierungen oder Oxidmischungen oder Mischungen von Elemente mit Oxiden mit gradueller Variation der Zusammensetzung als Funktion der Längenkoordination auf einem Substrat erzeugt werden, indem man die Elemente oder bereits binäre Legierungen von entsprechenden Targets aus auf einem mit einer Lochmaske versehenen Substrat erzeugt, wobei sich die Elementzusammensetzung je nach Entfernung von den Targets oder je nach Sputterwinkel ändert. Anschließend wird die Maske entfernt, und die erzeugten "Dots" werden zu den eigentlichen Materialien gesintert. Der Ausdruck "Dot" bezeichnet dabei räumlich voneinander getrennte Punkte oder Bereiche des Materials auf einem Substrat, die im wesentlichen gleiche Ausmaße aufweisen und vorzugsweise in regelmäßigen Abständen angeordnet sind, so daß sich ein Array ergibt. "Array" bedeutet die zweidimensionale, im wesentlichen gleichmäßig beanstandete Anordnung von Dots auf einer Substratfläche. Es ist auch möglich, Element- und Oxidpulver mit Korngrößen unterhalb 5µm in einem inerten Suspensionsmittel wie Kohlenwasserstoff unter Mitwirkung eines Dispergiermittels zu genügend stabilen Suspensionen zu suspendieren und Mischungen der Suspensionen wie bei den Oxiden beschrieben als Tröpfchen abzulegen, das Suspensionsmittel zu verdampfen und die so erzeugten Pulvermischungen auf dem Substrat zu sintern.

Als inertes, temperatur- und diffusionsstabiles Substratmaterial wird neben metallischen Substraten Siliziumcarbid bevorzugt, das auch genügend elektrisch leitfähig ist.

Dots der Oxide können auf einer Substratfläche auf erzeugt werden, indem über Dosierautomaten Mischungen von Salzen, vorzugsweise von Nitraten oder sonstigen löslichen Verbindungen in Form von Tropfen variabler Zusammensetzung abgelegt werden, das Lösungsmittel, vorzugsweise Wasser, verdampft wird, durch Temperaturerhöhung die Nitrate oder Verbindungen in die Oxide überführt werden und die Oxidmischungen in ihrer Gesamtheit anschließend gesintert werden. Pro Substratplatte mit Maßen von in der Größenordnung 10 * 10 cm werden 1.000 bis 10.000 Dots mit Abmessung (Durchmessern) von 0,2 bis 2 mm aufgebracht.

Der schnelle und zuverlässige Test der Materialien ist essentiell. Erfindungsgemäß können dazu zwei Analyseverfahren durchgeführt werden:
Die Erfindung betrifft ein Verfahren zur kombinatorischen Herstellung und Testung von Halbleitermaterialien für thermoelektrische Generatoren bei dem man auf einem leitfähigen flächigen Substrat ein Array aus Dots der Halbleitermaterialien mit unterschiedlicher Zusammensetzung erzeugt, das Substrat vorzugsweise unter einem inerten Gas wie Stickstoff oder Argon mit dem Array auf eine gewünschte Meßtemperatur temperiert und die Dots jeweils mit einem gekühlten Meßstift kontaktiert, wobei die Spannung ohne Belastung, Strom und Spannung bei sich verminderndem Lastwiderstand und/oder der Kurzschlußstrom gemessen, nachfolgend gespeichert und ausgewertet werden. Da die Materialproben von vornherein die Temperatur der Substratplatte aufweisen, wird erst beim Aufsetzen des gekühlten Meßstifts ein innerhalb von Sekunden wachsendes Temperaturgefälle erzeugt, das einen als Funktion der Temperaturdifferenz sich ändernden Kurzschlußstrom erzeugt, der gemessen und dessen Verlauf gespeichert wird. Zudem betrifft die Erfindung ein Verfahren zur kombinatoren Herstellung und Testung von Halbleitermaterialien für thermoelektrische Generatoren, bei dem man auf einem leitfähigen flächigen Substrat ein Array aus Dots der Halbleitermaterialien mit unterschiedlicher Zusammensetzung erzeugt, die Dots auf der dem Substrat gegenüberliegenden Seite mit einer leitfähigen unmagnetischen Platte kontaktiert, das Substrat und die Platte bei unterschiedlichen Temperaturen hält und elektrisch miteinander verbindet, wobei die Platte mit einer Magnetfeld-Sonde abgetastet wird und die Meßdaten gespeichert und ausgewertet werden.

Für beide Methoden werden die auf dem metallischen bzw. Silizumcarbid-Substrat befindlichen Dots z.B. mittels einer Mikrofeinschleifscheibe auf eine einheitliche Höhe abgeschliffen, und dabei wird gleichzeitig eine ebene Fläche geringer Rauhtiefe geschaffen. Man bringt die Substratplatte auf eine Meßtemperatur und kontaktiert mit einem gekühlten Meßstift unter definierter Auflagekraft die Dots.

Umgekehrt ist es auch möglich, die Substratplatte kalt zu lassen und den Meßstift zu heizen. In diesem Fall sollte das Heizen nicht elektrisch erfolgen, sondern, um das Einkoppeln von Fehlströmen zu verhindern, rein thermisch, beispielsweise, indem man einen Infrarotlaser in geeigneter Weise auf den Meßstift fokussiert.

Während der Meßstift aufliegt, werden die Spannung ohne Belastung, Strom und Spannung bei sich verminderndem Lastwiderstand sowie der Kurzschlußstrom gemessen. Eine rechnergesteuerte Meßapparatur benötigt zum Vermessen eines Materials inklusive Verfahren an den nächsten Dot um 10 Sekunden, was pro Tag die Vermessung von ca. 10.000 Dots bei einer Temperatur ermöglicht. Arbeitet man mit mehreren Meßstiften parallel, so können entsprechend mehr Dots vermessen werden. Die Meßwerte und Kurven können gespeichert und grafisch aufbereitet werden, so daß eine grafische Darstellung auf einen Blick die besseren Materialien anzeigt, deren Zusammensetzung man dann mit üblichen Methoden analysiert. Vorzugsweise wird unter Inertgas gearbeitet.

Eine weitere, jedoch berührungslose Testungs- bzw. Auswertevariante besteht darin, daß man auf die Dots, die sich auf der leitfähigen bzw. metallischen Substratplatte befinden, eine weitere leitfähige unmagnetische gekühlte Platte aufbringt und die beiden Platten elektrisch miteinander verbindet. Bei der anliegenden Temperaturdifferenz ist jeder Dot kurzgeschlossen. Der Kurzschlußstrom erzeugt im Dot und in den umliegenden Plattenteilen lokale Magnetfelder. Man rastert die Platte mit einer Magnetfeldsonde - z. B. einer Hallsonde oder einem Squid - ab und speichert die Meßwerte als Funktion der Koordinaten in einem Rechner. Die Stärke des Magnetfeldes ist proportional dem Kurzschlußstrom, aus seiner Richtung ergibt sich, ob das Material p- oder n- leitend ist. Die entsprechende grafische Aufbereitung der Meßwerte zeigt die besonders vorteilhaften Dots auf einen Blick.

Mit dieser Methode können 10.000 Dots innerhalb von 5 bis 30 min. vermessen werden, allerdings nur hinsichtlich der Dotierung und des Kurzschlußstroms.

Die Erfindung betrifft auch ein Array aus mindestens 10 unterschiedlichen erfindungsgemäßen Halbleitermaterialien auf einem leitfähigen Substrat.

Die erfindungsgemäßen Materialien werden gemäß dem Stand der Technik, wie er z. B. in WO 98/44562, US 5, 448, 109 oder US 5, 439, 528 dargestellt ist, in Module eingebracht und in diesen in Serie geschaltet.

## Patentansprüche

1. Thermoelektrischer Generator mit einem p- oder n-dotierten Halbleitermaterial, **dadurch gekennzeichnet, daß** das Halbleitermaterial ein mindestens ternäres Material aus der nachfolgenden Stoffklasse ist, das sich durch Kombination von mindestens 2 Verbindungen der Stoffklasse ergibt:
Antimonide
USb, CeSb, GdSb, LaSb, NdSb, PrSb und DySb, AlSb, CeSb, CrSb, FeSb, Mg₃Sb₂, Ni₅Sb₂ sowie CeSb₃ und NiSb₃,
wobei bis zu 10 Atom -% der Elemente ersetzt sein können durch Na, K, Rb, Cs, Zn, Cd, Al, Ga, Zr, Mg, S, Cu, Ag, Au, Ti, V, Nb, Ta, Cr, Mo, W, Mn, Re, Fe, Co, Ni, oder Gemischen davon, sofern sie nicht bereits in den Kombinationen vorliegen.

2. Thermoelektrischer Generator nach Anspruch 1, **dadurch gekennzeichnet, daß** das Halbleitermaterial eine binäre oder ternäre Legierung aus der Stoffklasse ist, wobei keine Elemente wie angegeben ersetzt sind.

3. Thermoelektrischer Generator nach Anspruch 1 oder 2, **dadurch gekennzeichnet, daß** die p- oder n- Dotierung durch Wahl der Mengenverhältnisse der Verbindungen oder die p- Dotierung mit Alkalimetallen und die n- Dotierung mit Sb, Bi, Se, Te, Br, oder I erfolgt.

4. Halbleitermaterial, wie es in einem der Ansprüche 1 bis 3 definiert ist.

5. Verfahren zur Herstellung von Halbleitermaterialien gemäß Anspruch 4 durch Sintern oder Zusammenschmelzen und nachfolgend Sintern von Mischungen der Elementpulver oder durch Sintern von Mischungen der Oxidpulver.

6. Verfahren zur kombinatorischen Herstellung und Testung von Halbleitermaterialien für thermoelektrische Generatoren nach Anspruch 4, bei dem man auf einem leitfähigen flächigen Substrat ein Array aus Dots der Halbleitermaterialien mit unterschiedlicher Zusammensetzung erzeugt, das Substrat mit dem Array auf eine gewünschte Meßtemperatur temperiert und die Dots jeweils mit einem gekühlten Meßstift kontaktiert, wobei die Spannung ohne Belastung, Strom und Spannung bei sich verminderndem Lastwiderstand und/oder der Kurzschlußstrom gemessen, nachfolgend gespeichert und ausgewertet werden.

7. Verfahren zur kombinatoren Herstellung und Testung von Halbleitermaterialien für thermoelektrische Generatoren nach Anspruch 4, bei dem man auf einem leitfähigen flächigen Substrat ein Array aus Dots der Halbleitermaterialien mit unterschiedlicher Zusammensetzung erzeugt, die Dots auf der dem Substrat gegenüberliegenden Seite mit einer leitfähigen unmagnetischen Platte kontaktiert, das Substrat und die Platte bei unterschiedlichen Temperaturen hält und elektrisch miteinander verbindet, wobei die Platte mit einer Magnetfeld - Sonde abgetastet wird und die Meßdaten gespeichert und ausgewertet werden.

8. Array aus mindestens 10 unterschiedlichen Halbleitermaterialien gemäß Anspruch 4 auf einem leitfähigen Substrat.
